# FASCICULE DE BREVET EUROPEEN

(11) **EP 1 774 588 B1**
(45) Date de publication et mention de la délivrance du brevet: **14.07.2010**
(21) Numéro de dépôt: 05782045.8
(22) Date de dépôt: 29.06.2005
(51) Int. Cl.: H01L 21/98, H01L 25/065, H01L 27/146

(54) **ASSEMBLAGE PAR ADHESION MOLECULAIRE DE DEUX SUBSTRATS**
ZUSAMMENFÜGEN ZWEIER SUBSTRATE MITTELS MOLEKULARER ADHÄSION
ASSEMBLING TWO SUBSTRATES BY MOLECULAR ADHESION

(30) Priorité: 30.06.2004 FR 0451374
(43) Date de publication de la demande: 18.04.2007
(73) Titulaire: Commissariat à l'Énergie Atomique et aux Énergies Alternatives, 75015 Paris (FR)
(72) Inventeur: FEUILLET, Guy, F-38410 SAINT MARTIN D'URIAGE (FR); MORICEAU, Hubert, F-38120 SAINT EGREVE (FR); POCAS, Stéphane, F-38000 GRENOBLE (FR); JALAGUIER, Eric, F-38410 SAINT MARTIN D'URIAGE (FR); MOUSSY, Norbert, F-38190 SAINTE-AGNES (FR)
(74) Mandataire: Poulin, Gérard
(86) Numéro de dépôt international: PCT/FR2005/050522
(87) Numéro de publication internationale: WO 2006/008411

(56) Documents cités:
- FR-A- 2 783 969
- US-B1- 6 274 892
- US-B1- 6 340 812
- TOND AND GÖSELE: "Semiconductor wafer bonding: Science and technology" 1999, JOHN WILLEY AND SONS , XP008042464 cité dans la demande page 217
- SHIYANG ZHU ET AL: "Buried cobalt silicide layer under thin silicon film fabricated by wafer bonding and hydrogen-induced delamination techniques" JOURNAL OF THE ELECTROCHEMICAL SOCIETY, ELECTROCHEMICAL SOCIETY. MANCHESTER, NEW HAMPSHIRE, US, vol. 146, no. 7, juillet 1999 (1999-07), pages 2712-2716, XP002291929 ISSN: 0013-4651

## Description

### DOMAINE TECHNIQUE

L'invention concerne un assemblage par adhésion moléculaire de deux substrats dont l'un au moins présente une topographie de surface, cet assemblage assurant un contact électrique localisé entre ces deux substrats. L'invention concerne en particulier un assemblage de photodétecteurs sur un circuit de lecture.

### ÉTAT DE LA TECHNIQUE ANTÉRIEURE

De nombreuses applications dans le domaine de l'optoélectronique et de la microélectronique nécessitent de mettre en contact, d'interfacer ou de connecter un matériau ayant ses fonctionnalités propres avec un circuit d'adressage ou de lecture.

Par exemple, pour réaliser une image numérique (quel que soit le domaine de longueur d'onde considéré : rayons X, UV, visibles ou IR), il convient de mettre en relation un détecteur de photons avec un circuit de lecture. De manière générale, les circuits de lecture sont constitués de pixels de taille pouvant varier, selon l'application visée, entre 10 et 200 µm. Ces pixels collectent chacun les charges photocréées à leur aplomb et cela nécessite donc la présence d'un contact électrique individuel entre le photodétecteur et chaque pixel.

Dans d'autres applications, on peut exciter localement un matériau photoémetteur, par exemple par injection de courant via un contact électrique individuel.

Une des techniques utilisées pour réaliser ce type de contact électrique consiste par exemple à avoir recours à des billes d'indium directement situées dans des ouvertures réalisées dans la couche isolante du circuit de lecture, au niveau de plots conducteurs. Cette hybridation par billes d'indium n'est possible que si les dimensions du circuit sont inférieures à quelques centimètres, en raison de problèmes de dilatation thermique.

Par ailleurs, la technique de l'adhésion moléculaire a déjà été envisagée pour mettre en relation intime deux matériaux cristallins différents (GaAs/Si, InP/Si, CdHgTe/Si...) dont on veut associer les fonctionnalités. On sait en effet que si des matériaux sont de paramètres de maille différents, il est difficile de les mettre en relation intime en réalisant la croissance épitaxiale de l'un sur l'autre. Dans ce cas en effet, les contraintes d'hétéroépitaxie se relâchent dans la couche en cours de croissance en formant des défauts cristallins tels que des dislocations. En ayant recours à des méthodes dites d'adhésion moléculaire, les liaisons sont reconstruites à l'interface entre les deux matériaux différents, assurant ainsi une continuité entre les deux cristaux. Les méthodes d'adhésion moléculaire permettent donc d'envisager des dispositifs complètement intégrés dans lesquels les interfaces doivent par exemple répondre à des critères de conduction électrique ou de transparence aux photons...

Le document US 6 274 892 B1 (KUB FRANCIS J ET AL) 14 août 2001 décrit l'attaque localisée de 100 nm de silicium à l'aplomb de zones conductrices, suivie de la formation d'une couche de siliciure sur toute la surface. Ensuite, une planarisation est effectuée de manière à ne conserver du siliciure qu'aux endroits où a eu lieu l'attaque. Finalement, le substrat obtenu est collé par adhésion moléculaire à un autre substrat. Ensuite, des contacts sont établis à partir de la surface de ce dernier substrat vers les zones conductrices en siliciure.

Le document FR 2 783 969 A1 (Commissariat à l'Energie Atomique) 31 mars 2003 décrit un procédé de fabrication d'un photodétecteur utilisant l'assemblage de deux substrats.

Cependant, le collage hétérogène par adhésion moléculaire entre matériaux différents n'est pas toujours possible en raison d'un éventuel manque d'affinité chimique entre les deux matériaux considérés. Une manière de contourner ce problème consiste à réaliser le collage via deux couches intermédiaires déposées respectivement sur les deux parties à mettre en contact. Le matériau choisi pour la réalisation de ces couches intermédiaires doit pouvoir être planarisé pour permettre la reconstruction des liaisons chimiques pour une adhésion parfaite (voir le document **[1]**).

Dans de nombreuses applications, on cherche à intégrer un matériau de propriété spécifique (par exemple un matériau photodétecteur, un matériau photoémetteur...) ou une structure multicouches déposée par épitaxie (du type diode, laser...), sur un circuit de lecture, par exemple du type CMOS ou TFT ou CCD..., dont la surface présente une certaine topographie. Or, le collage par adhésion moléculaire nécessite de mettre en contact des surfaces parfaitement planes à l'échelle atomique, sans topographie de surface. On réalise ainsi qu'il est impossible d'effectuer une adhésion moléculaire directe du matériau ou de la structure multicouches sur le circuit de lecture puisque les surfaces ne peuvent être directement mises en regard sur toute la surface considérée.

Une difficulté supplémentaire est de pouvoir assurer une bonne conduction électrique localement entre les deux substrats à assembler par exemple entre le photodétecteur et son circuit de collection en évitant toute fuite significative latérale (c'est-à-dire entre pixels). Ces fuites pourraient en effet engendrer une image avec un certain degré de flou.

### EXPOSÉ DE L'INVENTION

Le but de l'invention est de fournir un procédé de collage par adhésion moléculaire de deux structures, l'une au moins comportant une topographie de surface, ce collage permettant localement une conduction électrique verticale de bonne qualité entre ces deux structures. Quand on parle de la topographie présente à la surface d'un substrat ou structure, on parle du relief présent à la surface de ladite structure ou dudit substrat.

Ce but est atteint par un procédé d'assemblage tel que revendiqué dans la revendication 1.

L'épaisseur de la couche intermédiaire est déterminée pour que, en fonction de la distance séparant les zones situées sur le premier substrat et les zones correspondantes situées sur le deuxième substrat, de la distance séparant latéralement les différentes zones entre elles et de la résistivité de cette couche intermédiaire, lesdites liaisons électriques localisées puissent être obtenues à l'exclusion de toute autre liaison électrique.

On entend par couche d'enfouissement une couche qui permet de recouvrir la topographie ou relief de surface de la face du substrat sur laquelle elle est formée pour rendre cette surface compatible avec un collage moléculaire ultérieur.

Si seul un substrat comporte une topographie de surface, la couche intermédiaire sera déposée sur la face de ce substrat. Au contraire, si les deux substrats possèdent une topographie de surface, le premier et le deuxième substrat comporteront chacun une couche intermédiaire avec au moins une couche d'enfouissement disposée sur la face présentant une topographie de surface. Dans ce cas, il faudra tenir compte de l'épaisseur et/ou de la résistivité de chacune des couches intermédiaires pour permettre d'obtenir les liaisons électriques localisées souhaitées.

Précisons que lorsqu'on dit « mettre en contact les deux faces », il s'agit de mettre en contact les faces des substrats comprenant ou non une couche intermédiaire ou, comme on le verra plus loin, une couche de liaison. On peut par exemple mettre en contact la face du deuxième substrat avec la face du premier substrat comprenant une couche intermédiaire : la couche intermédiaire sera donc au final directement en contact avec la face du deuxième substrat.

Notons que lorsqu'on parle de face ou de surface, cette face n'est pas nécessairement faite du même matériau, mais peut être pluri-matériaux.

Avantageusement, la couche d'enfouissement peut permettre de rendre plane la face du premier substrat.

Avantageusement, la couche intermédiaire comprend également une couche de liaison formée sur la couche d'enfouissement, ladite couche de liaison permettant d'améliorer le collage par adhésion moléculaire entre les faces du premier et du deuxième substrat.

Selon une variante, si un seul substrat présente une topographie de surface, l'autre substrat ne présentant pas de topographie de surface comprend une couche de liaison permettant d'améliorer le collage par adhésion moléculaire entre les faces du premier et du deuxième substrat, cette couche de liaison ne perturbant pas les liaisons électriques localisées permises par la couche intermédiaire.

Ce dépôt d'une couche de liaison est utile dans le cas où il y aurait une mauvaise affinité entre la couche d'enfouissement du premier substrat et le deuxième substrat ou la couche d'enfouissement du deuxième substrat.

Cette couche de liaison du deuxième substrat doit être prise en compte lorsqu'on détermine l'épaisseur et/ou la résistivité de la couche intermédiaire du premier substrat. On peut ainsi considérer pour simplifier qu'elle fait partie à terme de la couche intermédiaire et qu'il faut donc en tenir compte pour l'optimisation du choix de la résistivité et/ou de l'épaisseur de la couche intermédiaire pour favoriser la conduction verticale par rapport à la conduction latérale.

Avantageusement, avant l'étape de mise en contact des faces, le procédé d'assemblage comprend en outre une étape de traitement des faces de contact du premier et/ou du deuxième substrat pour améliorer le collage par adhésion.

Selon un mode de réalisation particulier, le procédé comprend en outre, avant l'étape de formation d'une couche intermédiaire, une étape de formation d'une couche électriquement conductrice sur au moins une des zones situées sur la face du premier substrat et/ou sur au moins une des zones correspondantes situées sur une face du deuxième substrat, ladite couche électriquement conductrice étant apte à réagir avec tout ou partie de la couche d'enfouissement pour former une zone d'alliage conducteur au voisinage de l'interface.

Avantageusement, la couche électriquement conductrice réagit également avec la couche de liaison de la couche intermédiaire pour former un alliage conducteur participant à la zone d'alliage.

Avantageusement, la couche électriquement conductrice réagit avec au moins tout ou partie de la zone de surface du substrat en regard du substrat sur lequel elle a été formée pour former un alliage conducteur participant à la zone d'alliage. Ainsi, la zone d'alliage s'étend de part et d'autre de l'interface de collage.

Avantageusement, l'alliage est formé par traitement thermique de l'assemblage.

Avantageusement, le traitement thermique de l'assemblage a lieu après l'étape de collage par adhésion moléculaire.

Avantageusement, la température et le temps du traitement thermique sont choisis en fonction de l'alliage souhaité et de la quantité d'alliage que l'on veut obtenir. En effet, l'affinité entre le matériau de la couche d'enfouissement, ou de la couche d'enfouissement et de la couche de liaison adjacente, et le matériau de la couche de matériau électriquement conducteur pour former un alliage détermine la température à laquelle l'assemblage doit être porté pour permettre la constitution de l'alliage. De façon combinée ou alternative, cette étape de transformation peut comporter une étape de mise sous pression ou une étape d'électromigration connues de l'homme du métier pour former un alliage.

Avantageusement, la couche électriquement conductrice est en un métal et/ou un alliage conducteur.

Selon une variante de réalisation, la couche d'enfouissement est polie après sa formation.

Avantageusement, le premier substrat est un circuit de lecture.

Avantageusement, le deuxième substrat est en un matériau photodétecteur ou un matériau photoémetteur.

Avantageusement, les couches d'enfouissement du premier et du deuxième substrat sont en un même matériau. Les deux matériaux ont la même composition chimique.

Avantageusement, la couche d'enfouissement est en un matériau choisi parmi le silicium, le germanium, le SiC ou le SiGe.

Avantageusement, la couche de liaison est en silicium. Le matériau de la couche de liaison est choisi de manière à être compatible avec un collage par adhésion moléculaire.

Avantageusement, le procédé d'assemblage comprend en outre une étape de planarisation d'au moins une couche d'enfouissement ou de liaison présente sur une face du ou des substrats, cette étape étant réalisée avant l'étape consistant à mettre en contact les deux faces. Cette étape de planarisation est réalisée par une technique de polissage du type mécanique ou mécanochimique. Avantageusement, on planarise la topographie ou relief des surfaces à mettre en contact, voire on diminue leur microrugosité de surface jusqu'à obtenir des surfaces de la planéité nécessaire pour la réalisation d'une adhésion moléculaire.

Avantageusement, le procédé d'assemblage comprend en outre une étape de délimitation de zones conductrices dans la ou les couches séparant les deux substrats, lesdites zones conductrices étant localisées en regard desdites zones situées sur le premier substrat et desdites zones correspondantes sur le deuxième substrat et renforçant les liaisons électriques localisées permises par la ou les couches intermédiaires.

Avantageusement, l'étape de délimitation des zones conductrices dans la ou les couches séparant les deux substrats est réalisée avant l'étape de mise en contact des faces du premier et du deuxième substrat par implantation de cette ou ces couches séparant les deux substrats. On peut par exemple effectuer une implantation ionique dans cette ou ces couches séparant les deux substrats.

Avantageusement, l'étape de délimitation des zones conductrices dans la ou les couches séparant les deux substrats est réalisée après l'étape de collage par adhésion moléculaire des faces du premier et du deuxième substrat par un traitement thermique de l'ensemble ainsi obtenu de manière à ce que la ou les couches séparant les deux substrats et les zones situées sur les faces du premier et du deuxième substrat forment un alliage conducteur.

L'invention concerne également un procédé de réalisation d'un détecteur photosensible. Ce procédé comprend l'assemblage selon le procédé d'assemblage de l'invention de la face d'adhésion d'un premier substrat avec la face d'adhésion d'un second substrat,
- le premier substrat comprenant au moins en surface de sa face d'adhésion des zones électriquement conductrices et comprenant sur sa face d'adhésion une couche intermédiaire, ladite couche intermédiaire comprenant une couche d'enfouissement, recouvrant la topographie de la face du premier substrat,
- le second substrat comprenant au moins en surface une couche de détection de matériau sensible à la lumière à détecter.

Avantageusement, la couche de détection de matériau sensible est en silicium monocristallin.

Avantageusement, la couche de détection de matériau sensible est dopée en surface. On peut avoir un dopage n ou p. Le dopage superficiel de type p peut être réalisé par implantation ionique de la couche de liaison.

Avantageusement, le premier substrat comprenant au moins en surface de sa face d'adhésion des zones électriquement conductrices est un circuit de lecture. Il peut par exemple être un circuit VLSI.

Avantageusement, le second substrat est un SOI.

Le second substrat peut être en oxyde d'indium dopée à l'étain. Le second substrat forme ainsi un circuit de détection pour le détecteur photosensible. Il est transparent à la lumière et conducteur et vient faire une reprise de contact électrique collective sur toute la surface des zones électriquement conductrices du premier substrat (circuit de lecture).

Avantageusement, le second substrat est aminci.

Préférentiellement, le matériau de la couche d'enfouissement est aussi choisi de sorte d'avoir une ouverture de gap proche de celle du matériau utilisé pour le second substrat, de manière à minimiser la résistance d'interface entre la couche d'enfouissement et la couche de liaison.

Avantageusement, la couche d'enfouissement est en silicium poly-cristallin, microcristallin ou amorphe. La couche d'enfouissement peut être de différents types, amorphe, micro-cristallin, poly-cristallin, mais le matériau utilisé doit présenter le minimum de défauts afin de minimiser la génération thermique de charges. Par exemple, on peut utiliser du silicium polycristallin.

Selon une variante, la couche d'enfouissement est aplanie et/ou amincie avant l'assemblage avec le second substrat. L'amincissement peut permettre d'obtenir une couche d'enfouissement d'épaisseur faible par rapport à l'épaisseur de la couche de liaison de sorte que le rapport d'épaisseurs permette d'optimiser la réponse spectrale de la couche de liaison (qui joue le rôle de circuit de détection). La couche d'enfouissement est typiquement de 1 à 2 µm d'épaisseur.

Avantageusement, l'assemblage est recouvert d'une couche de matériau électriquement conducteur et transparent à la lumière à détecter (ITO).

L'invention concerne enfin un détecteur photosensible comprenant l'empilement suivant :
- un premier substrat comprenant au moins en surface de sa face d'adhésion des zones électriquement conductrices,
- une couche d'enfouissement en silicium polycristallin, microcristallin ou amorphe, déposée sur la face d'adhésion du premier substrat selon une épaisseur suffisante pour recouvrir la topographie de la face d'adhésion du premier substrat,
- une couche de détection en silicium mono-cristallin reportée sur la couche d'enfouissement et ayant subi un dopage de manière à former une diode dans l'épaisseur de la couche de détection et de la couche d'enfouissement,
- une couche de contact en matériau électriquement conducteur et transparent à la lumière à détecter.

Avantageusement, la couche de détection est localement rendue isolante. Cela permet de délimiter les pixels. La couche de détection est rendue localement isolante par exemple par gravure profonde ou par oxydation locale.

Enfin, l'invention concerne une structure microélectronique comprenant l'empilement suivant :
- un premier substrat présentant, sur sa face d'adhésion, une topographie de surface et au moins une zone électriquement conductrice,
- une couche d'enfouissement déposée sur cette face d'adhésion du premier substrat selon une épaisseur suffisante pour recouvrir la topographie de ladite face du premier substrat,
- un deuxième substrat comprenant sur sa face d'adhésion au moins une zone électriquement conductrice à l'aplomb de ladite au moins une zone électriquement conductrice du premier substrat, le deuxième substrat étant assemblé au premier substrat par collage moléculaire via la couche d'enfouissement.

La couche d'enfouissement est choisie de sorte qu'elle soit compatible avec un collage moléculaire avec le deuxième substrat.

La couche d'enfouissement permet également de relier électriquement et localement lesdites au moins une zone électriquement conductrice du premier et du deuxième substrat.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1C représentent les étapes d'un exemple de réalisation du procédé selon l'invention,
- les figures 2A à 2C illustrent les étapes d'un autre exemple de réalisation du procédé selon l'invention,
- les figures 3A à 3D illustrent encore les étapes d'un autre exemple de réalisation du procédé selon l'invention.

Il faut noter que les dimensions des couches et des substrats dans ces figures ne sont pas représentées à l'échelle.

### EXPOSÉ DÉTAILLÉ DE MODES DE RÉALISATION PARTICULIERS

Le coeur de l'invention repose sur un empilement original consistant à mettre en contact physique le matériau dont on veut exploiter les propriétés et un substrat, de préférence un circuit de lecture, en utilisant une technique basée sur le principe de l'adhésion moléculaire. Dans le cas plus particulier de l'application aux photodétecteurs, ce procédé doit permettre tout à la fois un transport des charges photogénérées du photodétecteur vers le circuit de lecture et une isolation latérale entre pixel pour conserver la résolution spatiale et le contraste dans l'image. Plusieurs variantes de ce procédé peuvent être envisagées pour répondre à ce critère de fonctionnement du dispositif. Nous allons à présent expliciter le mode de réalisation de différents dispositifs comprenant un circuit de lecture (premier substrat) et un substrat de matériau photodétecteur (deuxième substrat).

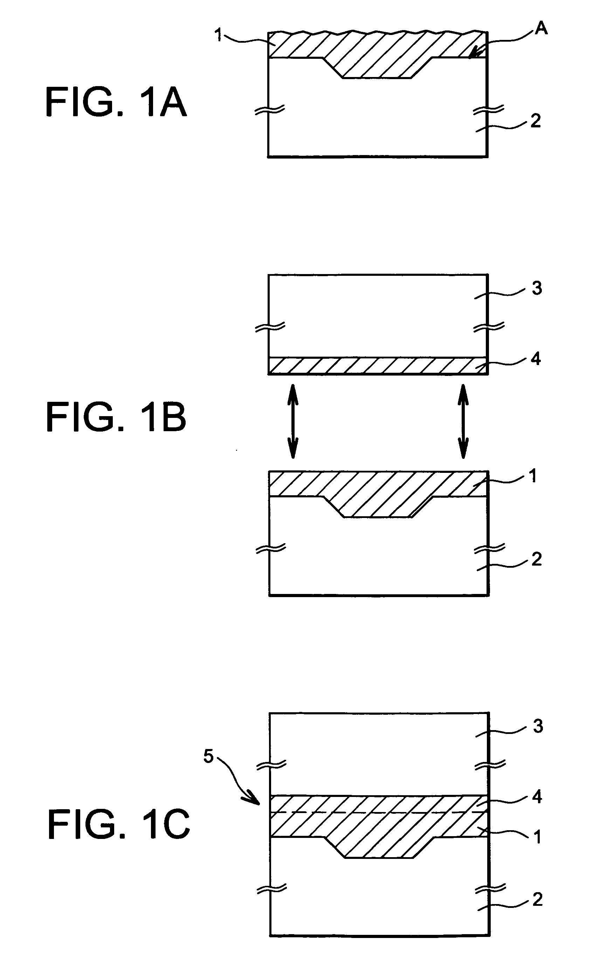

Dans un premier exemple, on réalise le collage d'un circuit de lecture, par exemple du type CMOS ou TFT ou CCD, et d'un substrat de matériau photodétecteur. On commence par déposer une couche d'enfouissement d'un premier matériau 1 sur la face A du circuit de lecture 2 qui comporte une topographie (figure 1A). La couche d'enfouissement de premier matériau 1 est déposée avec une épaisseur suffisante pour enterrer la topographie de surface du circuit de lecture 2, ainsi que pour «planariser» ultérieurement la surface du circuit ainsi «encapsulé». Ce premier matériau est choisi de sorte qu'il permette de réaliser la future adhésion moléculaire avec le deuxième substrat. Ensuite, on peut éventuellement déposer également une couche 4 de deuxième matériau sur le substrat 3 de matériau photodétecteur que l'on désire connecter sur le circuit de lecture 2. Ce deuxième matériau peut être identique au premier matériau. Cette couche 4 peut être utile si le substrat 3 en question possède une surface avec une topographie marquée. On peut également utiliser cette couche 4 de deuxième matériau par exemple pour enterrer les éventuelles rugosités de surface du substrat 3. De même, cette couche 4 est utile dans le cas où il y aurait un manque d'affinité chimique entre ce substrat 3 et le premier substrat 2 supportant la couche d'enfouissement de premier matériau 1 : la couche 4 joue alors le rôle d'une couche de liaison et permet alors d'obtenir une meilleure adhésion moléculaire entre les deux substrats.

Il est à noter que la couche d'enfouissement que l'on dépose sur le relief du ou des substrats et qui sert également au collage a une épaisseur suffisante pour enterrer ledit relief de surface ainsi que pour « planariser » ultérieurement la surface des substrats ainsi « encapsulés ».

Le matériau utilisé pour recouvrir la surface des substrats peut être un matériau pour lequel les techniques de planarisation (pour « enterrer » la topographie du circuit de lecture) et d'adhésion moléculaire sont maîtrisées ; on peut ainsi utiliser le silicium polycristallin ou amorphe. D'autres matériaux sont envisageables tels que le germanium. Le choix du matériau à mettre en oeuvre est également fait en tenant compte des contraintes auxquels il doit répondre pour assurer une connection du type voulu entre les deux substrats. Par exemple, dans le cas du collage d'un matériau photodétecteur avec un circuit de lecture, on peut vouloir que leur interface soit « transparente » aux électrons.

De préférence, les surfaces à mettre en contact subissent un traitement (par exemple un traitement chimique) pour améliorer le collage par adhésion moléculaire des deux structures à assembler. Avantageusement, on planarise ensuite tout ou partie des surfaces à mettre en contact par une technique de polissage, par exemple du type mécanique ou mécanochimique, jusqu'à ce qu'on obtienne des surfaces ayant une planéité nécessaire pour la réalisation d'une adhésion moléculaire. Enfin, on réalise l'adhésion moléculaire du circuit de lecture et du substrat selon une technique éprouvée pour le matériau d'enfouissement considéré (voir figure 1B). On peut par exemple réaliser un collage hydrophile/hydrophobe, suivi de recuits. On obtient au final un empilement 5 de deux substrats dont l'un au moins comporte une topographie de surface (voir figure 1C).

Le coeur de l'invention consiste à utiliser une technique de collage par adhésion moléculaire. Dans le procédé proposé, les éventuelles topographies de surface, présentes sur l'une des deux ou les deux plaques à coller, sont enfouies sous une couche de premier ou de deuxième matériau. Les surfaces des substrats à faire adhérer peuvent être préparées en vue de renforcer leur affinité chimique, de diminuer leur microporosité de surface et d'éliminer la contamination résiduelle de surface, pour finalement permettre cette adhérence moléculaire. Dans le cas où il y aurait un manque d'affinité chimique entre la couche d'enfouissement de premier matériau et le deuxième substrat, une couche de deuxième matériau apte au collage avec cette couche d'enfouissement de premier matériau peut être déposée sur ce deuxième substrat, même si le deuxième substrat n'a pas de relief à sa surface gênant le collage par adhésion moléculaire.

Dans cet exemple, qui s'applique à l'assemblage d'un circuit de lecture 2 et d'un matériau photodétecteur 3, l'épaisseur des couches d'enfouissement, c'est-à-dire des premier 1 et deuxième 4 matériaux, est déterminée de sorte que l'épaisseur finale entre les deux substrats permette l'isolation latérale des pixels du circuit de lecture. Ainsi, on assure un transport de charges du photodétecteur vers chaque pixel sans qu'il y ait de transport de charges latéral notable entre pixels voisins. On choisit le matériau des premier et/ou deuxième matériau servant au collage et/ou à l'enfouissement du relief en fonction de ses propriétés physiques, par exemple en fonction de sa résistivité, ainsi qu'en fonction de son épaisseur. La résistivité et l'épaisseur des couches interfaciales (c'est-à-dire la ou les couches séparant les deux substrats, par exemple une couche intermédiaire comprenant une couche d'enfouissement et une couche de liaison située sur le premier substrat, ainsi qu'une couche de liaison située sur le deuxième substrat) sont choisies de sorte que la résistance électrique entre les pixels soit supérieure à la résistance électrique entre le photodétecteur et le circuit de lecture correspondant.

La ou les couches intermédiaires entre le photodétecteur à base de semi-conducteur et le circuit de lecture doivent assurer un transfert de charges sans pertes verticalement tout en minimisant le transfert de charges entre pixels voisins qui pourraient provenir de fluctuations des tensions d'adressage des électrodes de contact du circuit. Ne pas prendre en compte ces contraintes résulterait en une image avec un certain degré de flou.

Pour une couche intermédiaire continue entre le matériau photodétecteur et le circuit de lecture, la minimisation de ces effets de pertes latérales peut se faire en jouant sur un jeu de paramètres tels que l'épaisseur de cette couche intermédiaire et sa résistivité.

Dans un premier temps, on peut se contenter d'une approche simple où l'on compare la résistance verticale à la résistance latérale entre pixels. Ceci ne fait donc intervenir que des facteurs de forme où entrent en compte les données géométriques fixées par l'épaisseur de la couche intermédiaire, la distance entre pixels et la taille des électrodes formant les pixels. On peut alors jouer sur les deux paramètres (résistivité et épaisseur de la couche) pour ajuster les valeurs des résistances verticale et latérale.

Une autre approche plus exacte est basée sur la comparaison entre la quantité de charges « déposées » dans chaque pixel et la quantité de charges qui pourraient transiter d'un pixel à l'autre sous l'effet de la différence de potentiel entre l'électrode considérée et les électrodes avoisinantes. On rappelle que la quantité de charges photocréées est fonction de la dose de photons reçus par le détecteur et donc d'un nombre de paires électrons-trous créées.

D'autres évaluations de la résistivité, et corrélativement de l'épaisseur, de la couche intermédiaire peuvent être réalisées qui tiennent compte de la méthode utilisée pour enregistrer le signal (intégration en fonction du comptage par exemple, dans le cas de photodétecteurs sur circuit CMOS).

Typiquement, dans le cas de la photodétection de rayons X, pour des gammes de résistivité de matériau photoconducteur de l'ordre de 10⁹ à 10¹⁰ pour des dimensions inter pixel de l'ordre de 30 à 50 micromètres et si on se limite à des épaisseurs de couche intermédiaire de quelques micromètres, la résistivité de la couche est estimée entre 10⁷ à 10⁹.

Pour un matériau photoconducteur de résistance 10¹⁰Ω.cm et une dimension inter pixel de 50 micromètres, l'épaisseur de silicium amorphe typiquement compatible avec les étapes de préparation de surface et de collage étant à 10 micromètres, la résistivité à privilégier pour maximiser la conduction verticale par rapport à la conduction latérale est de 10⁸Ω.cm. Cette résistivité peut être obtenue de façon connue par l'homme du métier en jouant sur le dopage du matériau et/ou les conditions d'élaboration (température, pression, température plasma...).

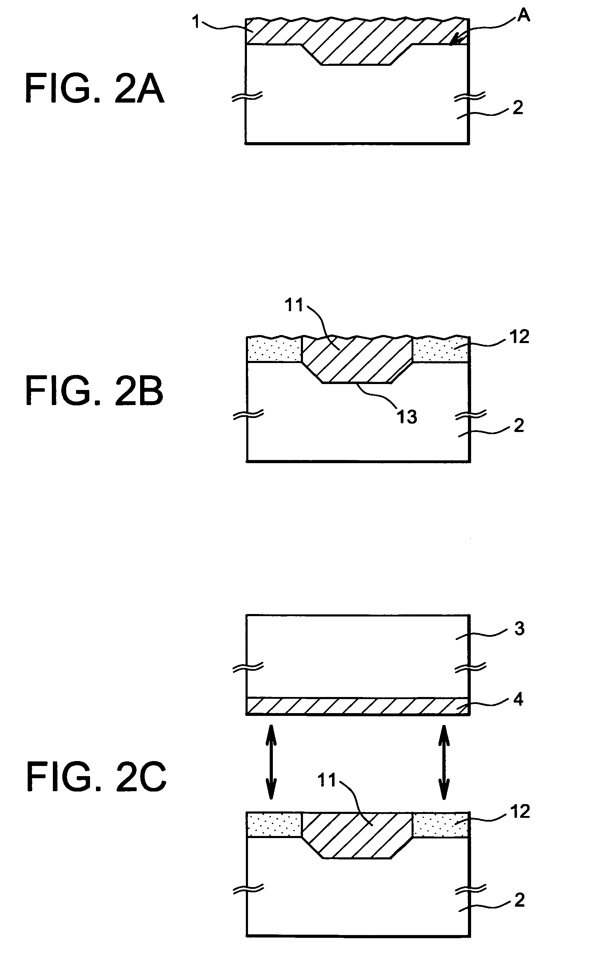

Selon un autre exemple, on dépose une couche d'enfouissement de premier matériau 1 (par exemple du silicium amorphe) sur le circuit de lecture 2 pour réaliser l'adhésion moléculaire avec une épaisseur suffisante pour enterrer la topographie de surface A du circuit et pour « planariser » ultérieurement la surface du circuit ainsi « encapsulé » (figure 2A). On dépose éventuellement une couche de deuxième matériau 4 (qui peut être identique au premier matériau) sur la plaque de substrat 3 en matériau photodétecteur que l'on désire connecter sur le circuit de lecture 2. Cette couche permet d'enterrer les éventuelles rugosités de surface de la plaque de substrat. Par ailleurs, on définit des zones isolantes 12 dans la couche d'enfouissement de premier matériau par exemple par implantation, par exemple ionique (implantation d'hydrogène par exemple), de parties de la couche d'enfouissement. Dans cet exemple, cette étape de « texturation » de la couche d'enfouissement a pour but d'isoler les pixels du circuit de lecture latéralement les uns des autres : on a des zones isolantes 12 et des zones 11 comprenant le premier matériau au dessus des pixels qui sont situés dans des cavités du circuit de lecture (dans la figure 2B, un pixel est situé dans la cavité 13). On réalise ensuite la planarisation de la surface des substrats et on procède à l'adhésion moléculaire (figure 2C). Notons que cette étape de planarisation aurait pu être réalisée avant l'étape de définition des zones isolantes dans la couche d'enfouissement. Dans le cas de l'assemblage d'un circuit de lecture avec un photodétecteur, cette approche est particulièrement utile lorsque les propriétés de la couche d'enfouissement ne permettent pas d'isoler les pixels par la simple présence de cette couche, par exemple, lorsque le matériau de la couche d'enfouissement a une résistivité trop faible.

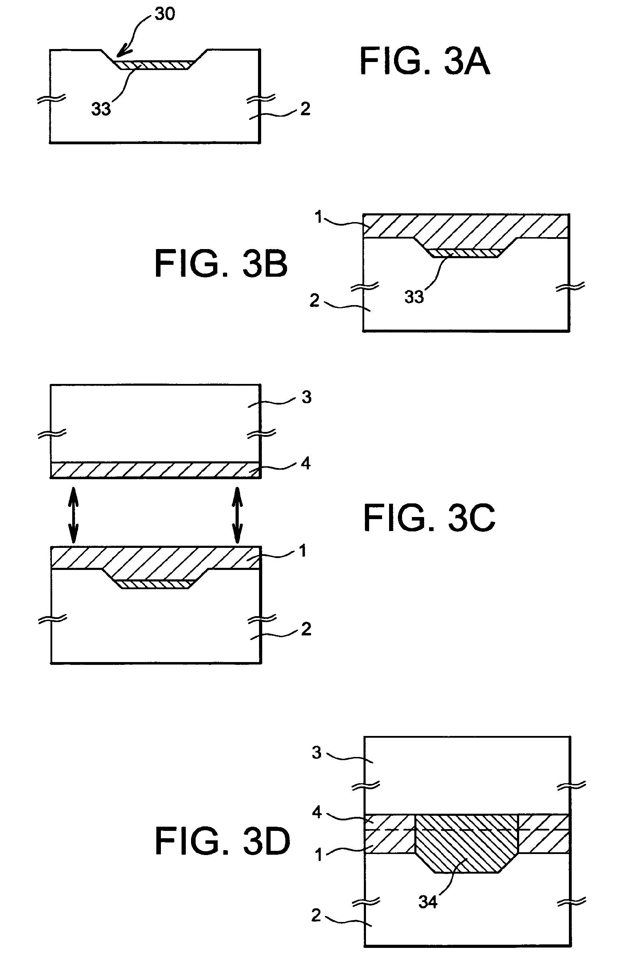

Un autre exemple permet de renforcer davantage la conduction verticale entre les pixels du circuit de lecture et la plaque de substrat photodétecteur par rapport à la conduction latérale entre pixels. On dispose d'un circuit de lecture 2 comportant des cavités 30 dont le fond est recouvert d'une couche électriquement conductrice 33 formée d'un empilement d'un ou plusieurs film en un métal ou en un alliage conducteur (figure 3A).Parmi les métaux, on peut citer un métal choisi parmi le nickel Ni, le platine Pt, le palladium Pd, le cobalt Co, le tungstène W, le tantale Ta, le titane Ti, le vanadium V, le chrome Cr, le manganèse Mn, le fer Fe, le molybdène Mo ou un mélange de ces éléments. Pour les alliages conducteurs, on peut citer les siliciures ou les germaniures de ces métaux et, de manière générale, tout matériau électriquement conducteur apte à former avec le matériau de la couche ajacente un alliage conducteur.

De même que dans les exemples précédents, on dépose sur le circuit de lecture 2 une couche d'enfouissement 1 suffisante de matériau sur la topographie de surface du circuit et éventuellement une couche de liaison (non représentée) et on planarise la surface à assembler (figure 3B). Puis, on procède au collage par adhésion moléculaire avec un substrat de matériau photodétecteur 3 comportant éventuellement une couche de liaison de deuxième matériau sur une de ses faces permettant d'améliorer le collage (figure 3C). La surface de la couche de liaison disposée sur le matériau photodétecteur peut subir une planarisation avant l'adhésion. L'adhésion peut être faite selon une technique adaptée au matériau de collage considéré (premier et/ou deuxième matériau), par exemple en traitant les surfaces des substrats et en les rendant hydrophile ou hydrophobe. Enfin, on induit la formation d'un composé conducteur 34 à l'aplomb des cavités 30 du circuit de lecture 2 en faisant réagir la couche électriquement conductrice sur tout ou partie de son épaisseur avec tout ou partie de l'épaisseur de la couche d'enfouissement (figure 3D). Cette réaction peut être induite par un traitement thermique adapté, par exemple à des températures qui doivent rester compatibles avec les matériaux utilisés. On provoque ainsi la formation d'un composé conducteur du type siliciure si la couche d'enfouissement est à base de Silicium ou du type germaniure si celle ci est à base de Germanium. On a alors un alliage conducteur joignant les deux substrats et participant à la conduction verticale entre ces deux substrats.

Avantageusement, l'intégralité de l'épaisseur de la couche d'enfouissement en regard des cavités 30 sera consommée lors de l'étape de formation de l'alliage et la couche électriquement conductrice réagira également avec les zones en regard des cavités 30 de la couche de surface du substrat de matériau photodétecteur (par exemple tout ou partie de l'épaisseur de la couche de liaison de deuxième matériau lorsque celle-ci existe ou directement le matériau situé en surface du substrat photodétecteur). Cette variante permet de créer une zone d'un ou plusieurs alliages (selon la nature des matériaux mis en jeu) s'étendant de part et d'autre de l'interface de collage renforçant ainsi la conduction verticale.

Dans une variante alternative ou combinée, une couche électriquement conductrice peut être présente également au niveau du substrat de matériau photodétecteur, recouverte d'une couche de liaison apte à former avec cette couche électriquement conductrice un alliage conducteur. Cet alliage peut être obtenu localement au niveau des plots de métal présent au fond des cavités par exemple par recuit laser.

Les matériaux de la ou des couches de liaison, de la ou des couches d'enfouissement et de la ou des couches électriquement conductrices doivent être choisis de sorte d'assurer la stabilité des matériaux des substrats 1 et 2 aux conditions d'élaboration (en particulier à la température d'élaboration) de ou des alliages conducteurs formés.

Enfin, un dernier exemple présente un imageur comprenant un détecteur photosensible matricé réalisé par report d'un film de silicium sur un circuit de lecture présentant une topologie de surface et comportant en surface des électrodes conductrices

Sur ce circuit de lecture présentant une topologie de surface, on dépose une couche de silicium non dopé (intrinsèque) sur la face comportant les électrodes ; cette couche sert de couche d'enfouissement du relief de la face du circuit de lecture et permet d'obtenir une bonne adhésion du circuit de lecture avec la couche de détection à assembler.

La couche de silicium déposée est ensuite planarisée de manière à obtenir une couche de silicium d'épaisseur faible par rapport à l'épaisseur du film de silicium mono-cristallin qui sera reporté par-dessus et qui servira de couche de détection. Le silicium déposé peut-être de différents types, amorphe, microcristallin, poly-cristallin, mais il doit présenter le minimum de défauts afin de minimiser la génération thermique de charges électriques. Préférentiellement, il pourra aussi être optimisé, par exemple, pour avoir une ouverture de gap proche de celle du silicium monocristallin, de manière à minimiser la résistance d'interface entre les deux types de silicium.

En plus de permettre l'enfouissement du relief du circuit de lecture et une bonne adhérence du circuit de lecture avec la couche de détection, la couche de silicium déposée et planarisée a également l'avantage de participer à la capture de la lumière et à la conversion de la lumière en charges électriques dans la continuité de la couche de détection constituée par la couche mono-cristalline de silicium reportée.

On reporte ensuite sur la couche d'enfouissement de silicium une couche de silicium mono-cristallin qui servira de couche de détection. On peut pour cela utiliser par exemple un substrat SOI, formé d'un substrat recouvert d'une couche de matériau isolant, elle même recouverte d'une couche mince de silicium monocristallin. Ce substrat SOI est assemblé par collage moléculaire avec le circuit de lecture via la couche d'enfouissement. On procède ensuite au retrait du substrat et de la couche isolante du substrat SOI par exemple par polissage mécano-chimique et/ou gravure chimique et/ou par fracture au niveau d'une zone fragile enterrée préalablement crée dans la couche mince de silicium par exemple par implantation d'espèces gazeuses (voir le document **[2]**) ou encore par toute autre technique appropriée. On obtient alors la structure désirée à savoir le circuit de lecture recouvert d'une couche de silicium déposée et d'une couche de silicium mono-cristallin (couche de détection).

Cette couche de silicium mono-cristallin est éventuellement amincie de manière à optimiser sa réponse spectrale. Typiquement, cette couche a une épaisseur de 1 à 2 µm .

On effectue ensuite un dopage superficiel de type p de la couche de silicium monocristallin, par exemple par implantation ionique, de manière à former une diode dans le silicium. En variante, l'étape de dopage peut avoir lieu avant l'étape d'assemblage. On peut par exemple doper superficiellement la couche mince de silicium monocristallin du substrat SOI et procéder au transfert de cette couche via un substrat intermédiaire comme décrit dans le document **[3].**

On dépose ensuite une couche transparente à la lumière à détecter et électriquement conductrice sur la couche de silicium mono-cristallin. On peut déposer par exemple une couche d'oxyde d'indium dopée à l'étain (ITO). Cette couche transparente et conductrice vient faire une reprise de contact électrique collective sur toute la surface du détecteur matricé. La zone sensible à la lumière et qui assure la conversion électrique des photons en charges électriques est donc localisée entre les électrodes métalliques inférieures du circuit de lecture (pixels) et l'électrode transparente supérieure. Elle est composée de la couche de silicium déposée, de la couche de silicium mono-cristallin reportée et de la couche dopée supérieure formant ainsi une diode dans l'épaisseur totale de ces couches.

Avantageusement, on pourra prévoir, pour assurer une meilleure isolation électrique entre les pixels, de créer dans la couche de détection des zones isolantes pour délimiter ces pixels. Pour cela, on pourra par exemple procéder à une gravure profonde dans la couche de silicium monocristallin ou encore à une oxydation localisée de cette couche par exemple par implantation ou à toute autre technique adaptée.

### BIBLIOGRAPHE

**[1]** Tong and Gôsele, "Semiconductor wafer bonding-Science and Technology", Ed. John Wiley and sons, p 215-219, 1999.
**[2]** Brevet US 5 374 564.
**[3]** Brevet FR 2 816 445.

## Revendications

1. Procédé d'assemblage d'un premier substrat (2) avec un deuxième substrat (3) pour permettre des liaisons électriques localisées entre des zones situées sur une face du premier substrat et des zones correspondantes situées sur une face du deuxième substrat, lesdites faces étant situées en regard l'une de au moins une face parmi la face du premier susbtrat et la face du deuxième substrat présentant une topographie de surface, le procédé d'assemblage comprenant les étapes consistant à :
- former une couche intermédiaire comprenant au moins une couche d'enfouissement (1, 4) sur ladite au moins une face (A) de manière à recouvrir la topographie de ladite au moins une face pour rendre cette face compatible avec un collage moléculaire ultérieur, la résistivité et l'épaisseur de la couche intermédiaire étant choisies pour permettre lesdites liaisons électriques localisées,
- mettre en contact la face du premier substrat avec la face du deuxième substrat cependant qu'au moins un des deux substrats comprend la couche intermédiaire, le premier substrat et le deuxième substrat étant positionnés de façon à pouvoir assurer les liaisons électriques entre les zones situées sur le premier substrat et les zones correspondantes situées sur le deuxième substrat,
- coller par adhésion moléculaire la face du premier substrat et la face du deuxième substrat.

2. Procédé d'assemblage selon la revendication précédente, **caractérisé en ce que** la couche intermédiaire comprend également une couche de liaison formée sur la couche d'enfouissement, ladite couche de liaison permettant d'améliorer le collage par adhésion moléculaire entre la face du premier substrat et la face du deuxième substrat.

3. Procédé d'assemblage selon la revendication 1 ou 2, **caractérisé en ce que,** un seul substrat présentant une topographie de surface, l'autre substrat ne présentant pas de topographie de surface comprend une couche de liaison permettant d'améliorer le collage par adhésion moléculaire entre la face du premier substrat et la face du deuxième substrat, cette couche de liaison ne perturbant pas les liaisons électriques localisées permises par la couche intermédiaire.

4. Procédé d'assemblage selon l'une quelconque des revendications précédentes, **caractérisé en ce qu'**il comprend en outre, avant l'étape de formation d'une couche intermédiaire, une étape de formation d'une couche électriquement conductrice sur au moins une des zones situées sur la face du premier substrat et/ou sur au moins une des zones correspondantes situées sur la face du deuxième substrat, ladite couche électriquement conductrice étant apte à réagir avec tout ou partie de la couche d'enfouissement pour former une zone d'alliage conducteur au voisinage de l'interface.

5. Procédé d'assemblage selon les revendications 2 et 4 prises ensemble, **caractérisé en ce que** la couche électriquement conductrice réagit également avec la couche de liaison de la couche intermédiaire pour former un alliage conducteur participant à la zone d'alliage.

6. Procédé d'assemblage selon l'une quelconque des revendications 4 ou 5, **caractérisé en ce que** la couche électriquement conductrice réagit avec au moins tout ou partie de la zone de surface du substrat en regard du substrat sur lequel elle a été formée pour former un alliage conducteur participant à la zone d'alliage.

7. Procédé d'assemblage selon l'une des revendications 4 à 6, **caractérisé en ce que** l'alliage est formé par traitement thermique de l'assemblage.

8. Procédé d'assemblage selon la revendication précédente, **caractérisé en ce que** le traitement thermique de l'assemblage a lieu après l'étape de collage par adhésion moléculaire.

9. Procédé d'assemblage selon l'une quelconque des revendications précédentes, **caractérisé en ce que** la couche électriquement conductrice est en un métal et/ou un alliage conducteur.

10. Procédé d'assemblage selon l'une quelconque des revendications précédentes, **caractérisé en ce que** la couche d'enfouissement est polie après sa formation.

11. Procédé d'assemblage selon l'une quelconque des revendications précédentes, **caractérisé en ce que** le premier substrat est un circuit de lecture.

12. Procédé d'assemblage selon l'une quelconque des revendications précédentes, **caractérisé en ce que** le deuxième substrat est en un matériau photodétecteur ou un matériau photoémetteur.

13. Procédé d'assemblage selon l'une quelconque des revendications précédentes, **caractérisé en ce que** la couche d'enfouissement est en un matériau choisi parmi le silicium, le germanium, le SiC ou le SiGe.

14. Procédé d'assemblage selon l'une quelconque des revendications 2 à 5, **caractérisé en ce que** la couche de liaison est en silicium.

15. Procédé d'assemblage selon l'une quelconque des revendications précédentes, **caractérisé en ce qu'**il comprend en outre une étape de planarisation d'au moins une couche d'enfouissement ou de liaison présente sur la face du premier substrat et/ou du deuxième substrat, cette étape étant réalisée avant l'étape consistant à mettre en contact la face du premier substrat et la face du deuxième substrat.

16. Procédé d'assemblage selon l'une quelconque des revendications précédentes, **caractérisé en ce qu'**il comprend en outre une étape de délimitation de zones conductrices (33) dans la ou les couches séparant le premier substrat et le deuxième substrat, lesdites zones conductrices étant localisées en regard desdites zones situées sur le premier substrat et desdites zones correspondantes sur le deuxième substrat et renforçant les liaisons électriques localisées permises par la ou les couches intermédiaires.

17. Procédé d'assemblage selon la revendication précédente, **caractérisé en ce que** l'étape de délimitation des zones conductrices dans la ou les couches séparant le premier substrat et le deuxième substrat est réalisée avant l'étape de mise en contact de la face du premier substrat et de la face du deuxième substrat par implantation de cette ou ces couches séparant le premier substrat et le deuxième substrat.

18. Procédé d'assemblage selon la revendication 16, **caractérisé en ce que** l'étape de délimitation des zones conductrices dans la ou les couches séparant le premier substrat et le deuxième substrat est réalisée après l'étape de collage par adhésion moléculaire de la face du premier substrat et de la face du deuxième substrat par un traitement thermique de l'ensemble ainsi obtenu de manière à ce que la ou les couches séparant le premier substrat et le deuxième substrat et les zones situées sur la face du premier substrat de la face du deuxième substrat forment un alliage conducteur.

19. Procédé de réalisation d'un détecteur photosensible, **caractérisé en ce qu'**il comprend l'assemblage selon l'une quelconque des revendications 1 à 18 de la face d'adhésion d'un premier substrat avec la face d'adhésion d'un second substrat,
- le premier substrat comprenant au moins en surface de sa face d'adhésion des zones électriquement conductrices et comprenant sur sa face d'adhésion une couche intermédiaire, ladite couche intermédiaire comprenant une couche d'enfouissement, recouvrant la topographie de la face du premier substrat,
- le second substrat comprenant au moins en surface une couche de détection de matériau sensible à la lumière à détecter.

20. Procédé de réalisation d'un détecteur photosensible selon la revendication précédente, **caractérisé en ce que** la couche de détection de matériau sensible est en silicium monocristallin.

21. Procédé de réalisation d'un détecteur photosensible selon la revendication 19 ou 20, **caractérisé en ce que** la couche de détection de matériau sensible est dopée en surface.

22. Procédé de réalisation d'un détecteur photosensible selon la revendication précédente, dans lequel le premier substrat comprenant au moins en surface de sa face d'adhésion des zones électriquement conductrices est un circuit de lecture.

23. Procédé de réalisation d'un détecteur photosensible selon l'une quelconque des revendications 19 à 22, dans lequel le second substrat est un SOI.

24. Procédé de réalisation d'un détecteur photosensible selon l'une quelconque des revendications 19 à 23, dans lequel le second substrat est aminci.

25. Procédé de réalisation d'un détecteur photosensible selon l'une quelconque des revendications 19 à 24, dans lequel la couche d'enfouissement est en silicium poly-cristallin, microcristallin ou amorphe.

26. Procédé de réalisation d'un détecteur photosensible selon l'une quelconque des revendications 19 à 25, dans lequel la couche d'enfouissement est aplanie et/ou amincie avant l'assemblage avec le second substrat.

27. Procédé de réalisation d'un détecteur photosensible selon l'une quelconque des revendications 19 à 26, dans lequel l'assemblage est recouvert d'une couche de matériau électriquement conducteur et transparent à la lumière à détecter (ITO).

28. Détecteur photosensible comprenant l'empilement suivant :
- un premier substrat (2) comprenant au moins en surface de sa face d'adhésion (A) une topographie de surface et des zones électriquement conductrices,
- une couche d'enfouissement (1, 4) en silicium poly-cristallin, microcristallin ou amorphe, déposée sur la face d'adhésion du premier substrat selon une épaisseur suffisante pour recouvrir la topographie de la face d'adhésion du premier substrat,
- une couche de détection en silicium monocristallin reportée sur la couche d'enfouissement et ayant subi un dopage de manière à former une diode dans l'épaisseur de la couche de détection et de la couche d'enfouissement,
- une couche de contact en matériau électriquement conducteur et transparent à la lumière à détecter.

29. Détecteur photosensible selon la revendication précédente, **caractérisé en ce que** la couche de détection est localement rendue isolante.

30. Structure microélectronique comprenant l'empilement suivant :
- un premier substrat (2) présentant, sur sa face d'adhésion (A), une topographie de surface et au moins une zone électriquement conductrice,
- une couche d'enfouissemet (1, 4) déposée sur cette face d'adhésion du premier substrat selon une épaisseur suffisante pour recouvrir la topographie de ladite face du premier substrat,
- un deuxième substrat (3) comprenant sur sa face d'adhésion au moins une zone électriquement conductrice à l'aplomb de ladite au moins une zone électriquement conductrice du premier substrat, le deuxième substrat étant assemblé au premier substrat par collage par adhésion moléculaire via la couche d'enfouissement.

## Claims

1. Assembly method of a first substrate (2) with a second substrate (3) to enable local electrical bonds between zones located on a face of the first substrate and corresponding zones located on a face of the second substrate, said faces being located facing each other, at least one face among the face of the first substrate and the face of the second substrate having a surface topography, the assembly method comprising the steps consisting of:
- forming an intermediate layer comprising at least one burial layer (1, 4) on said at least one face (A) in order to cover the topography of said at least one face to make this face compatible with an ulterior molecular bonding, the resistivity and the thickness of the intermediate layer being chosen to enable said local electrical bonds,
- bringing the face of the first substrate and the face of the second substrate into contact while at least one of these two substrates comprises the intermediate layer, the first substrate and the second substrate being positioned so as to create electrical bonds between areas located on the first substrate and the corresponding areas located on the second substrate,
- bonding the face of the first substrate and the face of the second substrate by molecular bonding.

2. Assembly method according to the previous claim, **characterised in that** the intermediate layer further comprises a bond layer formed on the burial layer, said bond layer improving molecular bonding between the face of the first substrate and the face of the second substrate.

3. Assembly method according to claim 1 or 2, **characterised in that,** if a single substrate has a surface topography, the other substrate that does not have a surface topography comprises a bond layer that improves molecular bonding between the face of the first substrate and the face of the second substrate, this bond layer not disturbing the local electrical bonds made possible by the intermediate layer.

4. Assembly method according to any one of the previous claims, **characterised in that** it further includes, before the step in which an intermediate layer is formed, a step to form an electrically conducting layer on at least one of the zones located on the face of the first substrate and/or on at least one of the corresponding areas located on the face of the second substrate, said electrically conducting layer being capable of reacting with all or part of the burial layer to form a conducting alloy zone close to the interface.

5. Assembly method according to claims 2 and 4 taken together, **characterised in that** the electrically conducting layer also reacts with the bond layer of the intermediate layer to form a conducting alloy participating in the alloy zone.

6. Assembly method according to claim 4 or 5, **characterised in that** the electrically conducting layer reacts with at least all or part of the surface zone of the substrate facing the substrate on which it was formed to form a conducting alloy participating in the alloy zone.

7. Assembly method according to any one of claims 4 to 6, **characterised in that** the alloy is formed by heat treatment of the assembly.

8. Assembly method according to the previous claim, **characterised in that** the heat treatment of the assembly takes place after the molecular bonding step.

9. Assembly method according to any one of the previous claims, **characterised in that** the electrically conducting layer is made from a metal and/or a conducting alloy.

10. Assembly method according to any one of the previous claims, **characterised in that** the burial layer is polished after it is formed.

11. Assembly method according to any one of the previous claims, **characterised in that** the first substrate is a read circuit.

12. Assembly method according to any one of the previous claims, **characterised in that** the second substrate is made from a photodetecting material or a photoemitting material.

13. Assembly method according to any one of the previous claims, **characterised in that** the burial layer is made from a material chosen from among silicon, germanium, SiC or SiGe.

14. Assembly method according to any one of claims 2 to 5, **characterised in that** the bond layer is made of silicon.

15. Assembly method according to any one of the previous claims, **characterised in that** it further comprises a step to flatten at least one burial layer or bond layer present on the face of the first substrate and/or the face of the second substrate, this step being made before the step consisting of bringing the face of the first substrate and the face of the second substrate into contact.

16. Assembly method according to any one of the previous claims, **characterised in that** it further comprises a step to delimit conducting zones (33) in the layer(s) separating the first substrate and the second substrate, said conducting zones being located facing said zones located on the first substrate and said corresponding zones on the second substrate, and reinforcing the local electrical bonds allowed by the intermediate layer(s).

17. Assembly method according to the previous claim, **characterised in that** the step to delimit the conducting zones in the layer(s) separating the first substrate and the second substrate is made before the step bringing the face of the first substrate and the face of the second substrates into contact by implantation of this or these layers separating the first substrate and the second substrate.

18. Assembly method according to claim 16, **characterised in that** the step to delimit the conducting zones in the layer(s) separating the first substrate and the second substrate is done after the molecular bonding step of the face of the first substrate and the face of the second substrate by heat treatment of the assembly thus obtained such that the layer(s) separating the first substrate and the second substrate and the areas located on the face of the first substrate and the face of the second substrate form a conducting alloy.

19. Method for making a photosensitive detector, **characterised in that** it includes the assembly according to any one of claims 1 to 18 of the bonding face of a first substrate with the bonding face of a second substrate,
- the first substrate comprising electrically conducting zones at least on the surface of its bonding face and comprising an intermediate layer on its bonding face, said intermediate layer comprising a burial layer, covering the topography of the face of the first substrate,
- the second substrate comprising, at least on its surface, a detection layer made of a material sensitive to the light to be detected.

20. Method for making a photosensitive detector according to the previous claim, **characterised in that** the sensitive material detection layer is made from mono-crystalline silicon.

21. Method for making a photosensitive detector according to claim 19 or 20, **characterised in that** the sensitive material detection layer is doped on the surface.

22. Method for making a photosensitive detector according to the previous claim, in which the first substrate comprising electrically conducting zones at least on the surface of its bonding face, is a read circuit.

23. Method for making a photosensitive detector according to any one of claims 19 to 22, in which the second substrate is an SOI.

24. Method for making a photosensitive detector according to any one of claims 19 to 23, in which the second substrate is thinned.

25. Method for making a photosensitive detector according to any one of claims 19 to 24, in which the burial layer is made from poly-crystalline, micro-crystalline or amorphous silicon.

26. Method for making a photosensitive detector according to any one of claims 19 to 25, in which the burial layer is flattened and/or thinned before being assembled with the second substrate.

27. Method for making a photosensitive detector according to any one of claims 19 to 26, in which the assembly is covered with a layer of electrically conducting material transparent to the light to be detected (ITO).

28. Photosensitive detector comprising the following stack:
- a first substrate (2) comprising at least on the surface of its bonding face (A) a surface topography and electrically conducting zones,
- a poly-crystalline, micro-crystalline or amorphous silicon burial layer (1, 4) deposited on the bonding face of the first substrate at a sufficient thickness to cover the topography of the bonding face of the first substrate,
- a mono-crystalline silicon detection layer transferred onto the burial layer, and having been doped so as to form a diode in the thickness of the detection layer and the burial layer,
- a contact layer made of an electrically conducting material transparent to the light to be detected.

29. Photosensitive detector according to the previous claim, **characterised in that** the detection layer is made locally insulating.

30. Microelectronic structure comprising the following stack:
- a first substrate (2) having, on its bonding face (A), a surface topography and at least one electrically conducting zone,
- a burial layer (1, 4) deposited on this bonding face of the first substrate with a sufficient thickness to cover the topography of said face of first substrate,
- a second substrate (3) comprising at least one electrically conducting zone on its bonding face vertically in line with the said at least one electrically conducting zone on the first substrate, the second substrate being assembled to the first substrate by molecular bonding through the burial layer.

## Patentansprüche

1. Verfahren zum Zusammenfügen eines ersten Substrats (2) mit einem zweiten Substrat (3), um lokalisierte elektrische Verbindungen zwischen Zonen, die auf einer Seite des ersten Substrats liegen, und entsprechenden Zonen zu ermöglichen, die auf einer Seite des zweiten Substrats liegen, wobei die Seiten einander gegenüber liegen, wobei wenigstens eine Seite von der Seite des ersten Substrats und der Seite des zweiten Substrats eine Oberflächentopographie aufweist, wobei das Verfahren zum Zusammenfügen die Schritte umfasst, die in Folgendem bestehen:
- Bilden einer Zwischenschicht, umfassend wenigstens eine Vergrabungsschicht (1,4), auf der wenigstens einen Seite (A) derart, dass die Topographie der wenigstens einen Seite bedeckt wird, um diese Seite kompatibel mit einer späteren molekularen Verklebung zu machen, wobei der spezifische Widerstand und die Dicke der Zwischenschicht so gewählt sind, dass sie die lokalisierten elektrischen Verbindung ermöglichen,
- In-Kontakt-Bringen der Seite des ersten Substrats mit der Seite des zweiten Substrats, wobei wenigstens eines der zwei Substrate die Zwischenschicht umfasst, wobei das erste Substrat und das zweite Substrat derart positioniert sind, dass sie die elektrischen Verbindungen zwischen den Zonen, die auf dem ersten Substrat liegen, und den entsprechenden Zonen, die auf dem zweiten Substrat liegen, sicherstellen können,
- Verkleben der Seite des ersten Substrats und der Seite des zweiten Substrats mittels molekularer Adhäsion.

2. Verfahren zum Zusammenfügen nach dem vorhergehenden Anspruch, **dadurch gekennzeichnet, dass** die Zwischenschicht ferner eine auf der Vergrabungsschicht gebildete Verbindungsschicht umfasst, wobei die Verbindungsschicht eine Verbesserung der Verklebung zwischen der Seite des ersten Substrats und der Seite des zweiten Substrats mittels molekularer Adhäsion ermöglicht.

3. Verfahren zum Zusammenfügen nach Anspruch 1 oder 2, **dadurch gekennzeichnet, dass** dann, wenn ein einziges Substrat eine Oberflächentopographie aufweist, das andere Substrat, welches keine Oberflächentopographie aufweist, eine Verbindungsschicht umfasst, die eine Verbesserung der Verklebung zwischen der Seite des ersten Substrats und der Seite des zweiten Substrats mittels molekularer Adhäsion ermöglicht, wobei diese Verbindungsschicht die lokalisierten elektrischen Verbindungen nicht stört, die durch die Zwischenschicht ermöglicht werden.

4. Verfahren zum Zusammenfügen nach einem der vorhergehenden Ansprüche, **dadurch gekennzeichnet, dass** es ferner, vor dem Schritt des Bildens einer Zwischenschicht, einen Schritt des Bildens einer elektrisch leitenden Schicht auf wenigstens einer der Zonen umfasst, die auf der Seite des ersten Substrats liegen, und/oder auf wenigstens einer der entsprechenden Zonen, die auf der Seite des zweiten Substrats liegen, wobei die elektrisch leitende Schicht dazu ausgelegt ist, mit der gesamten Vergrabungsschicht oder einem Teil davon zu reagieren, um in der Nähe der Grenzfläche eine leitende Legierungszone zu bilden.

5. Verfahren zum Zusammenfügen nach den Ansprüchen 2 und 4 in Kombination, **dadurch gekennzeichnet, dass** die elektrisch leitende Schicht ferner mit der Verbindungsschicht der Zwischenschicht reagiert, um eine leitende Legierung zu bilden, die an der Legierungszone mitwirkt.

6. Verfahren zum Zusammenfügen nach einem der Ansprüche 4 oder 5, **dadurch gekennzeichnet, dass** die elektrisch leitende Schicht mit wenigstens der ganzen oder einem Teil der Oberflächenzone des Substrats gegenüber dem Substrat reagiert, auf dem sie gebildet worden ist, um eine leitende Legierung zu bilden, die an der Legierungszone mitwirkt.

7. Verfahren zum Zusammenfügen nach einem der Ansprüche 4 bis 6, **dadurch gekennzeichnet, dass** die Legierung durch thermische Behandlung des Zusammenfügungsverbunds gebildet wird.

8. Verfahren zum Zusammenfügen nach dem vorhergehenden Anspruch, **dadurch gekennzeichnet, dass** die thermische Behandlung des Zusammenfügungsverbunds nach dem Schritt des Verklebens mittels molekularer Adhäsion erfolgt.

9. Verfahren zum Zusammenfügen nach einem der vorhergehenden Ansprüche, **dadurch gekennzeichnet, dass** die elektrisch leitende Schicht aus einem Metall und/oder aus einer leitenden Legierung gebildet ist.

10. Verfahren zum Zusammenfügen nach einem der vorhergehenden Ansprüche, **dadurch gekennzeichnet, dass** die Vergrabungsschicht nach ihrer Bildung poliert wird.

11. Verfahren zum Zusammenfügen nach einem der vorhergehenden Ansprüche, **dadurch gekennzeichnet, dass** das erste Substrat ein Lesestromkreis ist.

12. Verfahren zum Zusammenfügen nach einem der vorhergehenden Ansprüche, **dadurch gekennzeichnet, dass** das zweite Substrat aus einem Photodetektormaterial oder aus einem Photoemittermaterial gebildet ist.

13. Verfahren zum Zusammenfügen nach einem der vorhergehenden Ansprüche, **dadurch gekennzeichnet, dass** die Vergrabungsschicht aus einem Material gebildet ist, welches ausgewählt ist aus Silizium, Germanium, SiC oder SiGe.

14. Verfahren zum Zusammenfügen nach einem der Ansprüche 2 bis 5, **dadurch gekennzeichnet, dass** die Verbindungsschicht aus Silizium gebildet ist.

15. Verfahren zum Zusammenfügen nach einem der vorhergehenden Ansprüche, **dadurch gekennzeichnet, dass** es ferner einen Schritt des Planarmachens wenigstens einer Vergrabungs- oder Verbindungsschicht umfasst, die auf der Seite des ersten Substrats und/oder des zweiten Substrats vorhanden ist, wobei dieser Schritt vor dem Schritt durchgeführt wird, der darin besteht, die Seite des ersten Substrats und die Seite des zweiten Substrats in Kontakt zu bringen.

16. Verfahren zum Zusammenfügen nach einem der vorhergehenden Anspruche, **dadurch gekennzeichnet, dass** es ferner einen Schritt des Eingrenzens leitfähiger Zonen (33) in der oder in den Schichten umfasst, die das erste Substrat und das zweite Substrat trennen, wobei die leitfähigen Zonen gegenüber denjenigen Zonen lokalisiert sind, die auf dem ersten Substrat liegen, und den entsprechenden Zonen auf dem zweiten Substrat, und sie die lokalisierten elektrischen Verbindungen verstärken, die durch die Zwischenschicht(en) ermöglicht werden.

17. Verfahren zum Zusammenfügen nach dem vorhergehenden Anspruch, **dadurch gekennzeichnet, dass** der Schritt des Eingrenzens der leitfähigen Zonen in der oder den Schichten, die das erste Substrat und das zweite Substrat trennen, vor dem Schritt des In-Kontakt-Bringens der Seite des ersten Substrats und der Seite des zweiten Substrats durch Implantation dieser Schicht(en) erfolgt, die das erste Substrat und das zweite Substrat trennt/trennen.

18. Verfahren zum Zusammenfügen nach Anspruch 16, **dadurch gekennzeichnet, dass** der Schritt des Eingrenzens der leitfähigen Zonen in der oder den Schichten, die das erste Substrat und das zweite Substrat trennen, nach dem Schritt des Verklebens der Seite des ersten Substrats und der Seite des zweiten Substrats mittels molekularer Adhäsion durch ein thermischen Behandeln der derart erhaltenen Gesamtanordnung erfolgt, derart, dass die Schicht(en), die das erste Substrat und das zweite Substrat und die Zonen, die auf der Seite des ersten Substrats liegen, von der Seite des zweiten Substrats trennt/trennen, eine leitende Legierung bilden.

19. Verfahren zur Herstellung eines photoempfindlichen Detektors, **dadurch gekennzeichnet, dass** es das Zusammenfügen der Adhäsionsseite eines ersten Substrats mit der Adhäsionsseite eines zweiten Substrats nach einem der Ansprüche 1 bis 18 umfasst,
- wobei das erste Substrat wenigstens an der Oberfläche seiner Adhäsionsseite elektrisch leitfähig Zonen umfasst und an seiner Adhäsionsseite eine Zwischenschicht umfasst, wobei die Zwischenschicht eine Vergrabungsschicht umfasst, die die Topographie der Seite des ersten Substrats bedeckt.
- wobei das zweite Substrat wenigstens an der Oberfläche eine Defiektionsschicht aus einem Material umfasst, das für das zu detektierende Licht empfindlich ist.

20. Verfahren zur Herstellung eines photoempfindlichen Detektors nach dem vorhergehenden Anspruch, **dadurch gekennzeichnet, dass** die Detektionsschicht aus empfindlichem Material aus monokristallinem Silizium gebildet ist.

21. Verfahren zur Herstellung eines photoempfindlichen Detektors nach Anspruch 19 oder 20, **dadurch gekennzeichnet, dass** die Detektionsschicht aus empfindlichem Material an der Oberfläche dotiert ist.

22. Verfahren zur Herstellung eines photoempfindlichen Detektors nach dem vorhergehenden Anspruch, bei dem das erste Substrat, das wenigstens an der Oberfläche seiner Adhäsionsseite elektrisch leitfähige Zonen umfasst, ein Lesestromkreis ist.

23. Verfahren zur Herstellung eines photoempfindlichen Detektors nach einem der Ansprüche 19 bis 22, bei dem das zweite Substrat ein SOI ist.

24. Verfahren zur Herstellung eines photoempfindlichen Detektors nach einem der Ansprüche 19 bis 23, bei dem das zweite Substrat verdünnt ist.

25. Verfahren zur Herstellung eines photoempfindlichen Detektors nach einem der Ansprüche 19 bis 24, bei dem die Vergrabungsschicht aus polykristallinem, mikrokristallinem oder amorphen Silizium gebildet ist.

26. Verfahren zur Herstellung eines photoempfindlichen Detektors nach einem der Ansprüche 19 bis 25, bei dem die Vergrabungsschicht vor dem Zusammenfügen mit dem zweiten Substrat plangemacht und/oder verdünnt ist.

27. Verfahren zur Herstellung eines photoempfindlichen Detektors nach einem der Ansprüche 19 bis 26, bei dem der Zusammenfügungsverbund mit einer Schicht aus einem Material bedeckt ist, das elektrisch leitet und für das zu detektierende Licht transparent ist (ITO).

28. Photoempfindlicher Detektor, umfassend die folgende Stapelung:
- ein erstes Substrat (2), das wenigstens an der Oberfläche seiner Adhäsionsseite (A) eine Oberflächentopographie und elektrisch leitfähige Zonen umfasst,
- eine Vergrabungsschicht (1,4) aus polykristallinem, mikrokristallinem oder amorphen Silizium, die auf der Adhäsionsseite des ersten Substrats mit einer Dicke aufgebracht ist, die ausreichend ist, um die Topographie der Adhäsionsseite des ersten Substrats zu bedecken,
- eine Detektionsschicht aus monokristallinem Silizium, die auf die Vergrabungsschicht übertragen ist und eine Dotierung erfahren hat, derart, dass sie in der Dicke der Detektionsschicht und der Vergrabungsschicht eine Diode bildet,
- eine Kontaktschicht aus einem Material, das elektrisch leitend und für das zu detektierende Licht transparent ist.

29. Photoempfindlicher Detektor nach dem vorhergehenden Anspruch, **dadurch gekennzeichnet, dass** die Detektionsschicht lokal isolierend gemacht ist.

30. Mikroelektronische Struktur, umfassend die folgende Stapelung:
- ein erstes Substrat (2), das auf seiner Adhäsionsseite (A) eine Oberflächentopographie und wenigstens eine elektrisch leitfähige Zone aufweist,
- eine Vergrabungsschicht (1,4), die auf dieser Adhäsionsseite des ersten Substrats mit einer Dicke aufgebracht ist, die ausreichend ist, um die Topographie der Seite des ersten Substrats zu bedecken,
- ein zweites Substrat (3), das auf seiner Adhäsionsseite wenigstens eine elektrisch leitfähige Zone senkrecht zu der wenigstens einen elektrisch leitfähigen Zone des ersten Substrats umfasst, wobei das zweite Substrat mit dem ersten Substrat mittels Verkleben durch molekulare Adhäsion über die Vergrabungsschicht zusammengefügt ist.
